# EUROPEAN PATENT APPLICATION

(11) **EP 4 716 017 A1**
(43) Date of publication of application: **25.03.2026**
(21) Application number: 25195334.5
(22) Date of filing: 12.08.2025
(51) Int. Cl.: H01R 12/70, H01R 12/78, H01R 13/631, H01R 12/71, H01R 12/79, H05K 1/182, H05K 1/189

(54) **GUIDE COMPONENT**

(30) Priority: 24.09.2024 JP 2024165503
(71) Applicant: Japan Aviation Electronics Industry, Limited, Tokyo 150-0043 (JP)
(72) Inventor: OOSAKA, Junji, Tokyo, 150-0043 (JP)
(74) Representative: Prüfer & Partner mbB Patentanwälte · Rechtsanwälte

(57) **Abstract**

A guide component has a base formed with an accommodation portion. The accommodation portion has two first sides each extending along a first horizontal direction and two second sides each extending along a second horizontal direction. The accommodation portion is provided with a first press-fit projection projecting inward in the horizontal plane from the first side and a second press-fit projection projecting inward in the horizontal plane from the second side. Under an attached state where the guide component is attached to a connector, the connector is located in the accommodation portion, is pressed against the first press-fit projection in the second horizontal direction and is pressed against the second press-fit projection in the first horizontal direction.

## Description

### BACKGROUND OF THE INVENTION

This invention relates to a guide component configured to guide mating of a connector with a mating connector.

For example, this type of guide component is disclosed in JP2011-129459A (Patent Document 1), the content of which is incorporated herein by reference.

Referring to Fig. 16, Patent Document 1 discloses a mating guide component (guide component) 90 configured to guide mating of a connector with a mating connector (not shown).

The connector 95 is mounted and fixed on a circuit board 98 in an up-down direction. The connector 95 is provided with a plurality of lock portions 97. Each of the lock portions 97 is located at a lower edge of the connector 95. The guide component 90 is provided with a plurality of lock claws 92 which correspond to the lock portions 97, respectively. When the illustrated guide component 90 is moved toward the connector 95, each of the lock claws 92 is moved under the corresponding lock portion 97 and is engaged with the corresponding lock portion 97. The thus-moved guide component 90 is attached to the connector 95. The mating connector (not shown) is mateable with the connector 95, to which the guide component 90 is attached, from above. The guide component 90 guides the mating connector when the mating connector is mated with the connector 95.

According to the aforementioned structure, the guide component 90 attached to the connector 95 is movable relative to the connector 95 to some extent in a horizontal plane perpendicular to the up-down direction. Thus, a position of the attached guide component 90 will vary to some extent in the horizontal plane. Accordingly, the mating connector (not shown) might be inaccurately positioned relative to the connector 95 in the horizontal plane in a process in which the mating connector is mated with the connector 95.

### SUMMARY OF THE INVENTION

It is therefore an object of the present invention to provide a guide component which can accurately position a mating connector relative to a connector in a horizontal plane.

An aspect of the present invention provides a guide component which is configured to be attached to a connector mateable with a mating connector and is configured to guide mating of the connector with the mating connector. The guide component has a base and two guide portions. The base is formed with an accommodation portion. The accommodation portion passes through the base in an up-down direction and has two first sides and two second sides. Each of the first sides extends along a first horizontal direction perpendicular to the up-down direction. Each of the second sides extends along a second horizontal direction perpendicular to both the up-down direction and the first horizontal direction. The accommodation portion is provided with at least one first press-fit projection and at least one second press-fit projection. The at least one first press-fit projection projects inward in a horizontal plane perpendicular to the up-down direction from one of the two first sides. The at least one second press-fit projection projects inward in the horizontal plane from one of the two second sides. Under an attached state where the guide component is attached to the connector, the connector is located in the accommodation portion, is pressed against the at least one first press-fit projection in the second horizontal direction and is pressed against the at least one second press-fit projection in the first horizontal direction. The guide portions are located at opposite sides of the base in the first horizontal direction, respectively, with the accommodation portion located therebetween. The guide portions guide the mating connector toward the connector when the mating connector is mated with the connector.

According to an aspect of the present invention, when the guide component is attached to the connector, the connector is pressed against the first press-fit projection to be positioned in the second horizontal direction and is pressed against the second press-fit projection to be positioned in the first horizontal direction. In other words, the guide component is reliably positioned relative to the connector in the horizontal plane defined by the first horizontal direction and the second horizontal direction. The guide portions of the thus-positioned guide component guide the mating connector toward the connector when the mating connector is mated with the connector. The mating connector guided by the guide portions can be mated with the connector while being accurately positioned relative to the connector in the horizontal plane. Thus, an aspect of the present invention provides a guide component which can accurately position a mating connector relative to a connector in a horizontal plane.

An appreciation of the objectives of the present invention and a more complete understanding of its configuration may be had by studying the following description of the preferred embodiment and by referring to the accompanying drawings.

### BRIEF DESCRIPTION OF THE DRAWINGS

Fig. 1 is a perspective view showing a connection device according to an embodiment of the present invention, wherein a connector and a mating connector of the connection device are under a separated state where they are separated from each other.
Fig. 2 is another perspective view showing the connection device of Fig. 1, wherein the connector and the mating connector are under a mated state where they are mated with each other.
Fig. 3 is a perspective view showing the mating connector of Fig. 1, wherein the mating connector is mounted and fixed on a lower surface of a mating circuit member.
Fig. 4 is a perspective view showing a connector assembly comprising the connector and a guide component of Fig. 1, wherein the connector is mounted and fixed on an upper surface of a circuit member, and the guide component is under a pre-attached state where it is not yet attached to the connector.
Fig. 5 is a top view showing the connector assembly of Fig. 4, wherein the guide component is under an attached state where it is attached to the connector, and an outline of the mating connector in a mating process is schematically illustrated with dashed line.
Fig. 6 is a side view showing the connector assembly of Fig. 5.
Fig. 7 is another side view showing the connector assembly of Fig. 5.
Fig. 8 is a bottom view showing the connector assembly of Fig. 5.
Fig. 9 is a bottom view showing the connector assembly of Fig. 8, wherein the circuit member and a reinforcement member are not illustrated.
Fig. 10 is a bottom view showing a part of the connector assembly enclosed by dashed line of Fig. 9.
Fig. 11 is a top view showing the guide component of Fig. 4.
Fig. 12 is a side view showing the guide component of Fig. 11.
Fig. 13 is another side view showing the guide component of Fig. 11.
Fig. 14 is a bottom view showing the guide component of Fig. 11, wherein outlines of opposite ends of the connector under the attached state are partially illustrated with dashed line, and a part of the guide component enclosed by chain dotted line is enlarged and illustrated.
Fig. 15 is a bottom view showing an accommodation portion of the guide component of Fig. 14, wherein outlines of the opposite ends of the connector under the attached state are partially illustrated with dashed line.
Fig. 16 is a perspective view showing a connector and a guide component of Patent Document 1.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the spirit and scope of the present invention as defined by the appended claims.

### DETAILED DESCRIPTION

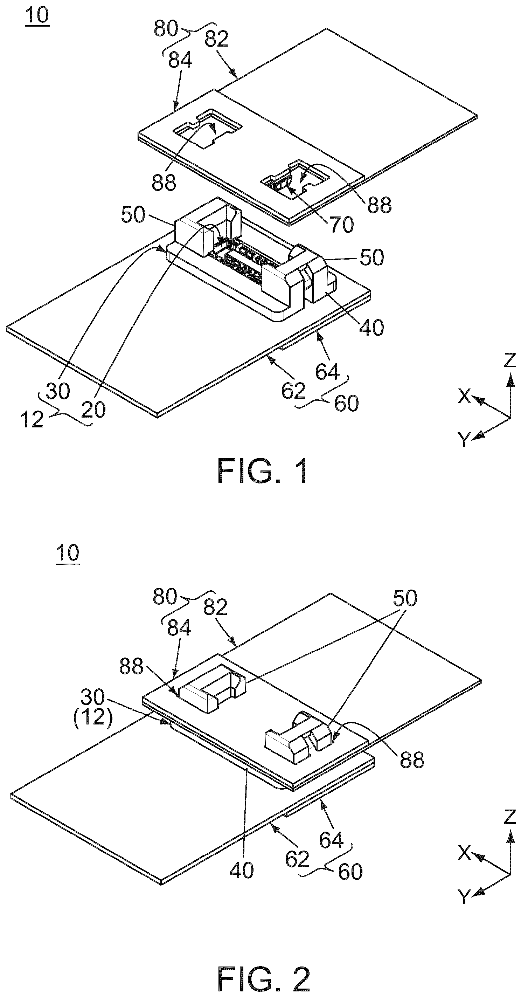

As shown in Fig. 1, a connection device 10 according to an embodiment of the present invention comprises a connector assembly 12 and a mating connector 70. The connector assembly 12 comprises a connector 20 and a guide component 30. The illustrated guide component 30 is under an attached state where the guide component 30 is attached to the connector 20. As described above, the connection device 10 of the present embodiment comprises the connector 20, the guide component 30 and the mating connector 70. However, the present invention is not limited thereto. For example, the connection device 10 may comprise another member in addition to the aforementioned members.

Referring to Figs. 1 and 2, the connector 20 is mateable with the mating connector 70, which is located above the connector 20 in an up-down direction, along the up-down direction. The guide component 30 is configured to be attached to the connector 20 mateable with the mating connector 70 and is configured to guide the mating of the connector 20 with the mating connector 70. The up-down direction of the present embodiment is the Z-direction. In the present embodiment, "upward" means the positive Z-direction, and "downward" means the negative Z-direction. The words such as the up-down direction do not indicate the absolute positional relation relative to the ground but merely indicate a relative positional relation under a definition in which the up-down direction is the mating direction along which the connector 20 and the mating connector 70 are configured to be mated with each other.

Referring to Figs. 1 to 3, the connector 20 of the present embodiment is a receptacle, and the mating connector 70 of the present embodiment is a plug. The mating connector 70 is partially received in the connector 20 under a mated state where the connector 20 and the mating connector 70 are mated with each other as shown in Fig. 2. However, the present invention is not limited thereto. For example, the connector 20 may be a plug, and the mating connector 70 may be a receptacle.

Hereafter, explanation will be made about the mating connector 70 of the present embodiment.

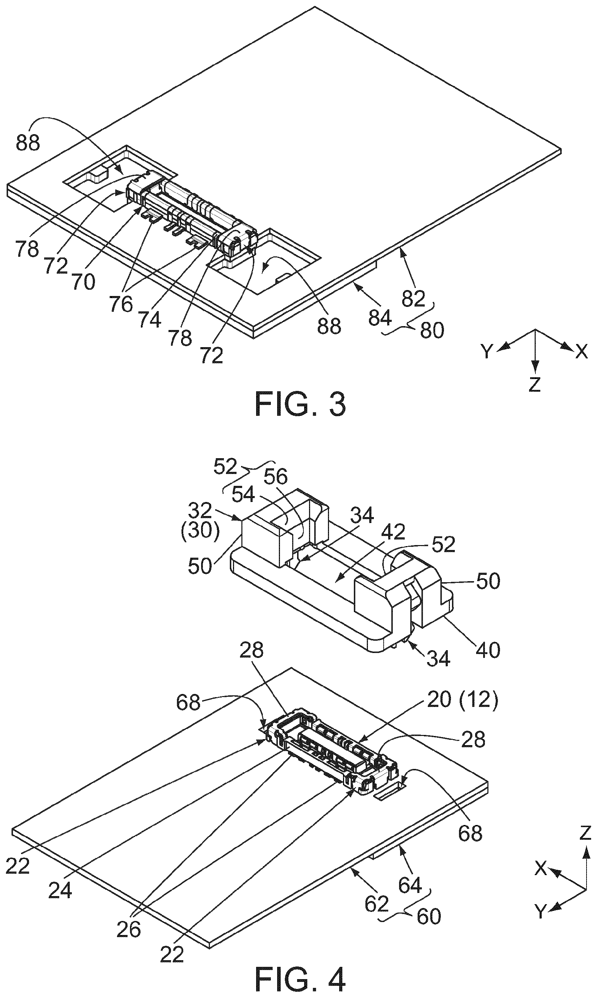

Referring to Fig. 3, the mating connector 70 of the present embodiment comprises a mating housing 74 made of insulator, a plurality of mating terminals 76 each made of conductor and two mating hold-downs 78 each made of conductor. The mating terminals 76 are held by the mating housing 74 and are arranged along a first horizontal direction (pitch direction) perpendicular to the up-down direction. The mating hold-downs 78 are held by opposite end portions 72 of the mating housing 74 in the first horizontal direction, respectively. The first horizontal direction of the present embodiment is the X-direction. The mating connector 70 of the present embodiment has the aforementioned structure. However, the structure of the mating connector 70 of the present invention is not specifically limited.

The mating connector 70 of the present embodiment is placed on a lower surface of a mating object 80. Thus, the mating connector 70 is a so-called on-board connector. The mating object 80 of the present embodiment comprises a mating circuit member 82 and a mating reinforcement member 84. The mating circuit member 82 is a flexible printed circuits (FPC) cable. The mating reinforcement member 84 is made of rigid material such as stainless steel and extends along a horizontal plane (XY-plane) perpendicular to the up-down direction. The mating reinforcement member 84 is fixed on an upper surface of an end part of the mating circuit member 82 in a second horizontal direction perpendicular to both the up-down direction and the first horizontal direction. The thus-provided mating reinforcement member 84 reinforces the easily bendable mating circuit member 82. The second horizontal direction of the present embodiment is the Y-direction. The mating circuit member 82 reinforced by the mating reinforcement member 84 extends along the horizontal plane.

The mating object 80 of the present embodiment has the aforementioned structure. However, the present invention is not limited thereto. For example, the mating circuit member 82 may be a rigid and unbendable circuit board. In this instance, the mating reinforcement member 84 does not need to be provided. Thus, the mating object 80 may comprise only a rigid circuit board.

The mating connector 70 of the present embodiment is configured to be mounted and fixed on the mating object 80. In detail, the mating terminals 76 and the mating hold-downs 78 are fixed on and connected to conductive pads (not shown) provided on a lower surface of the mating circuit member 82 via soldering, etc. However, a method for fixing the mating connector 70 on the mating object 80 is not specifically limited.

The mating object 80 of the present embodiment is formed with two openings 88. Each of the openings 88 passes through the mating circuit member 82 and the mating reinforcement member 84 of the mating object 80 in the up-down direction. The openings 88 are located at opposite sides of the mating connector 70 in the first horizontal direction, respectively, and are located at positions same as each other in the second horizontal direction. The openings 88 of the present embodiment are formed as described above. However, the present invention is not limited thereto. For example, the openings 88 may be formed as necessary.

Hereafter, explanation will be made about the connector 20 (see Fig. 4) of the present embodiment.

Referring to Fig. 4, the connector 20 of the present embodiment comprises a housing 24 made of insulator, a plurality of terminals 26 each made of conductor and two hold-downs 28 each made of conductor. The terminals 26 are provided so as to correspond to the mating terminals 76 (see Fig. 3) of the mating connector 70 (see Fig. 3), respectively. The terminals 26 are held by the housing 24 and are arranged along the first horizontal direction. The hold-downs 28 are held by opposite end portions 22 of the housing 24 in the first horizontal direction, respectively. The connector 20 of the present embodiment has the aforementioned structure. However, the structure of the connector 20 of the present invention is not specifically limited.

The connector 20 of the present embodiment is placed on an upper surface of an object 60. Thus, the connector 20 is an on-board connector. The object 60 of the present embodiment comprises a circuit member 62 and a reinforcement member 64. The circuit member 62 is an FPC cable. The reinforcement member 64 is made of rigid material such as stainless steel and extends along the horizontal plane. The reinforcement member 64 is fixed on a lower surface of an end part of the circuit member 62 in the second horizontal direction. The thus-provided reinforcement member 64 reinforces the easily bendable circuit member 62. The circuit member 62 reinforced by the reinforcement member 64 extends along the horizontal plane.

The object 60 of the present embodiment has the aforementioned structure. However, the present invention is not limited thereto. For example, the circuit member 62 may be a rigid and unbendable circuit board. In this instance, the reinforcement member 64 does not need to be provided. Thus, the object 60 may comprise only a rigid circuit board.

The connector 20 of the present embodiment is configured to be mounted and fixed on the object 60. In detail, the terminals 26 and the hold-downs 28 are fixed on and connected to conductive pads (not shown) provided on an upper surface of the circuit member 62 via soldering, etc. However, a method for fixing the connector 20 on the object 60 is not specifically limited.

The object 60 of the present embodiment is formed with two passing holes 68. Each of the passing holes 68 passes through the circuit member 62 and the reinforcement member 64 of the object 60 in the up-down direction. The passing holes 68 are located at opposite sides of the connector 20 in the first horizontal direction, respectively, and are located at positions same as each other in the second horizontal direction. The passing holes 68 of the present embodiment are formed as described above. However, the present invention is not limited thereto. For example, the passing holes 68 may be formed as necessary.

Referring to Fig. 1, the illustrated connector 20 and the illustrated mating connector 70 are under a separated state where they are separated from each other. The mating connector 70 under the separated state is located above the connector 20 and faces the connector 20. Referring to Figs. 1 and 2, the connector 20 and the mating connector 70 take the mated state shown in Fig. 2 when the mating object 80, on which the mating connector 70 under the separated state is mounted, is moved downward. Referring to Fig. 2 together with Figs. 3 and 4, under the mated state, each of the terminals 26 of the connector 20 is connected to the corresponding mating terminal 76 of the mating connector 70, and thereby the circuit member 62 is electrically connected with the mating circuit member 82.

Hereafter, explanation will be made about the guide component 30 of the present embodiment.

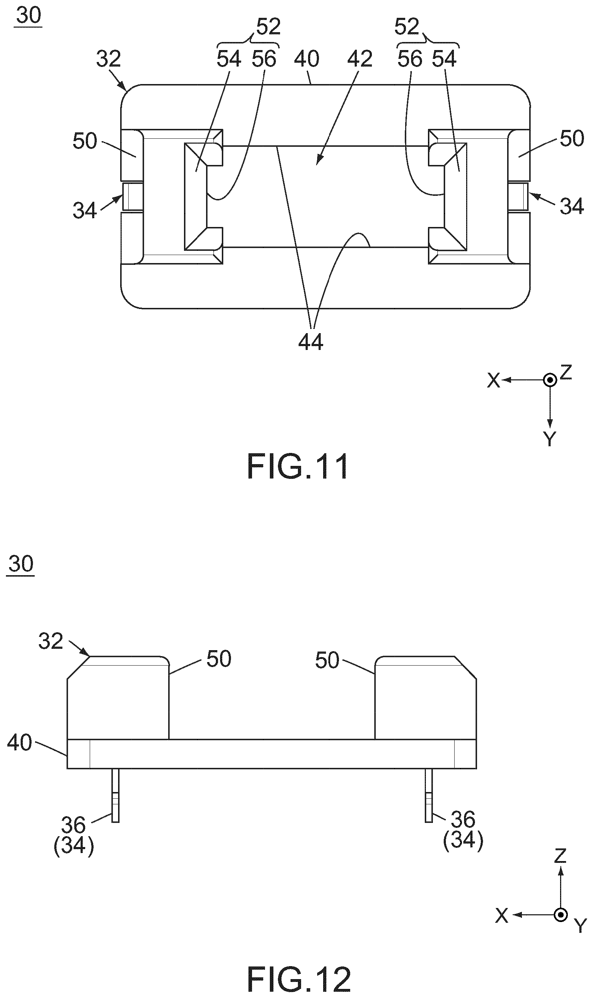

Referring to Figs. 4 and 11, the guide component 30 of the present embodiment comprises a main member 32 made of insulator and two fixation members 34 each made of metal.

The main member 32 has a base 40 and two guide portions 50. Thus, the guide component 30 has the base 40 and the two guide portions 50. The base 40 has a rectangular flat-plate shape perpendicular to the up-down direction. The base 40 is formed with an accommodation portion 42. The accommodation portion 42 passes through the base 40 in the up-down direction. The accommodation portion 42 has a rectangular shape in the horizontal plane and is completely enclosed by an inner wall surface of the base 40 in the horizontal plane. The guide portions 50 are located at opposite sides of the base 40, respectively, with the accommodation portion 42 located therebetween in the first horizontal direction and are located at positions same as each other in the second horizontal direction. Each of the guide portions 50 projects upward beyond an upper surface of the base 40.

The main member 32 of the present embodiment has the aforementioned structure. However, the present invention is not limited thereto. For example, the main member 32 may further have another portion in addition to the base 40 and the guide portions 50. The shape of the base 40 is not specifically limited, provided that the accommodation portion 42 is formed. The guide portions 50 may be located at positions different from each other in the second horizontal direction.

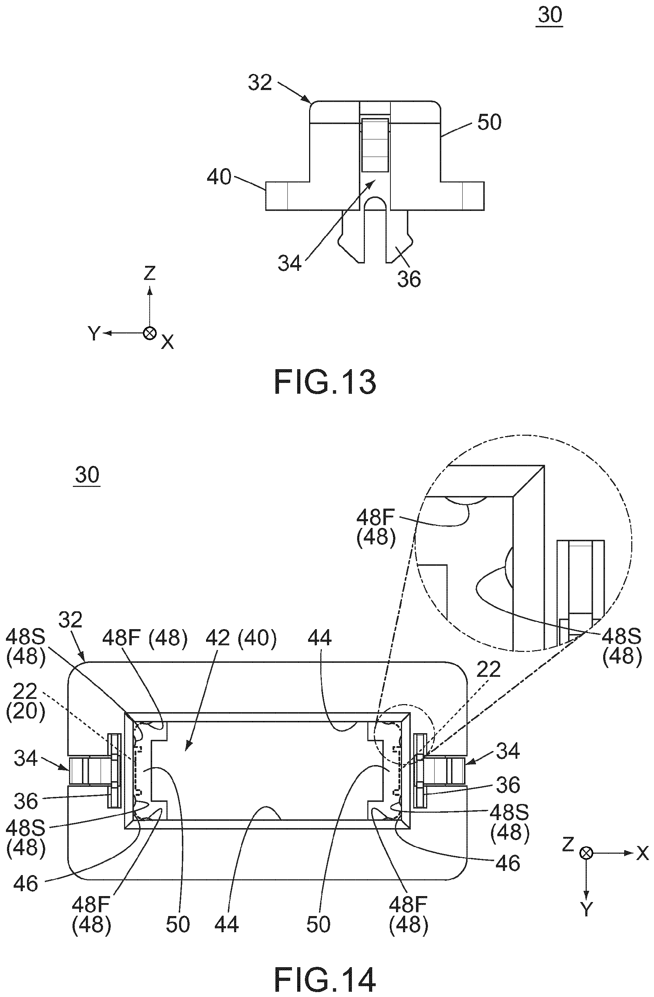

The fixation members 34 of the present embodiment are fixed to the guide portions 50 of the main member 32, respectively. As shown in Fig. 12, the fixation members 34 are located on opposite sides of the main member 32 in the first horizontal direction, respectively. As shown in Figs. 12 and 13, each of the fixation members 34 has a fixed portion 36. Thus, the guide component 30 has the two fixed portions 36. Each of the fixed portions 36 projects downward beyond a lower surface of the base 40. Each of the fixed portions 36 is resiliently deformable. In detail, each of the fixed portions 36 is divided into two branches in the second horizontal direction. Each of the branches partially protrudes outward in the second horizontal direction and is movable in the second horizontal direction in accordance with resilient deformation of the fixed portion 36.

Referring to Fig. 4, the guide component 30 of the present embodiment comprises only the main member 32 and the fixation members 34. However, the present invention is not limited thereto. For example, the guide component 30 may further comprise another member in addition to the aforementioned members. The fixation members 34 may be provided as necessary. Moreover, each of the fixation members 34 may be a part of the main member 32. Thus, the guide component 30 may comprise only the main member 32.

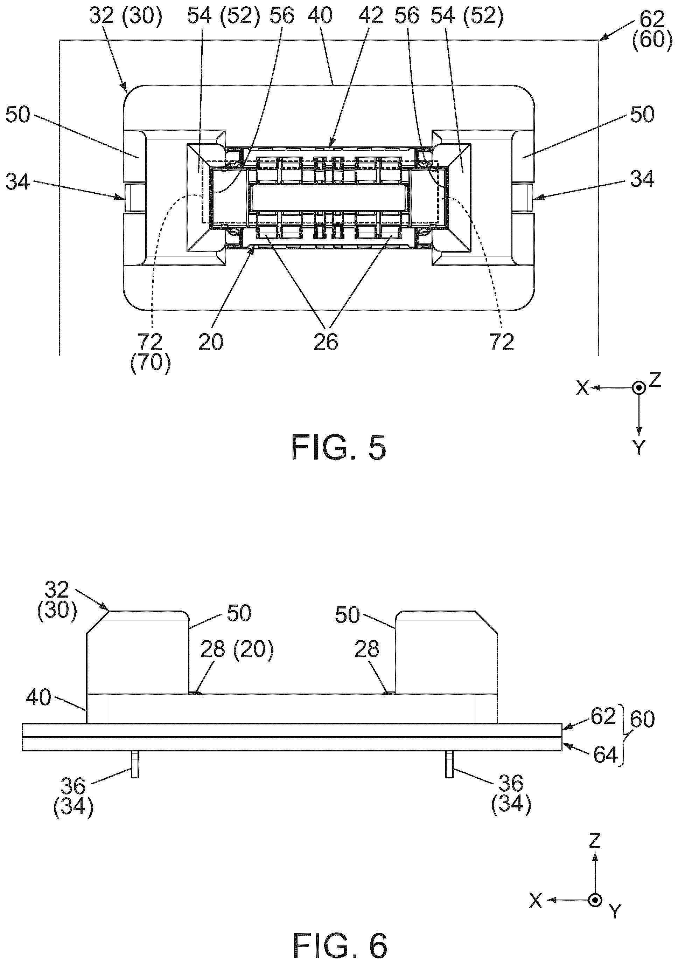

Referring to Fig. 4 together with Fig. 1, the guide component 30 can be attached from above to the connector 20 mounted on the object 60. The connector 20 is accommodated in the accommodation portion 42 of the guide component 30 when the guide component 30 is attached to the connector 20. Referring to Figs. 5 and 6, the guide component 30 is placed on the upper surface of the object 60 and encloses the connector 20 in the horizontal plane under the attached state. The base 40 has a size in the up-down direction which is almost same as a size of the connector 20 in the up-down direction. As shown in Fig. 6, the thus-shaped connector 20 is invisible except for upper ends of the hold-downs 28 when the guide component 30 is seen along the second horizontal direction under the attached state.

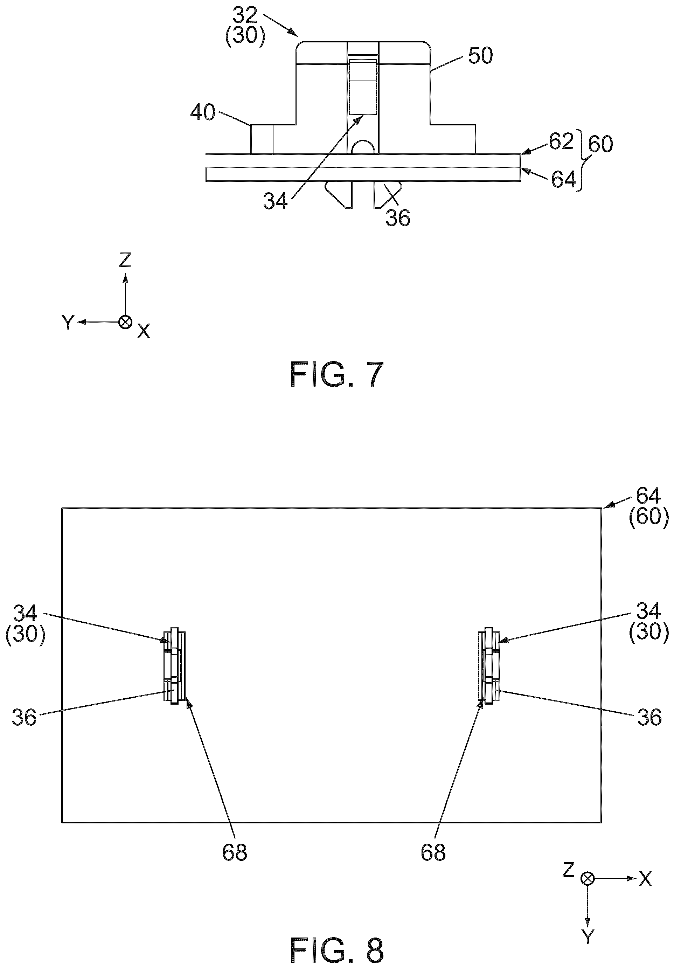

Referring to Fig. 8, the two passing holes 68 of the object 60 are located at positions which correspond to positions of the fixed portions 36 of the two fixation members 34 in the horizontal plane. Each of the passing holes 68 has a size larger than a size of the corresponding fixed portion 36 in the first horizontal direction. Each of the passing holes 68 has a size smaller than a size of the corresponding fixed portion 36 in the second horizontal direction when the fixed portion 36 is under an initial state where the fixed portion 36 is not resiliently deformed. During a process in which the guide component 30 is attached to the connector 20, each of the fixed portions 36 passes through the passing hole 68 while being resiliently deformed. Referring to Figs. 6 to 8, each of the fixed portions 36 returns to the initial state under the attached state and is located under a lower surface of the object 60. When the guide component 30 under the attached state is pulled upward, the fixed portions 36 are brought into abutment with the lower surface of the object 60, and thereby the guide component 30 cannot be detached from the connector 20.

The guide component 30 of the present embodiment is configured to be fixed to the object 60 by the fixed portions 36 under the attached state as described above. The guide component 30 is not fixed to the connector 20 even under the attached state. Even when the guide component 30 under the attached state is pulled upward by a large force which might partially damage the object 60, the connector 20 is not damaged and is not detached from the object 60. The guide component 30 can be easily detached from the connector 20 and the object 60 by resiliently deforming the fixed portions 36. However, the present invention is not limited thereto. For example, the fixed portions 36 may be securely fixed to the object 60 via soldering, etc., after the fixed portions 36 pass through the passing holes 68. Moreover, the guide component 30 may be fixed to the connector 20 under the attached state.

Hereafter, explanation will be made about the accommodation portion 42 (see Fig. 14) of the guide component 30 of the present embodiment.

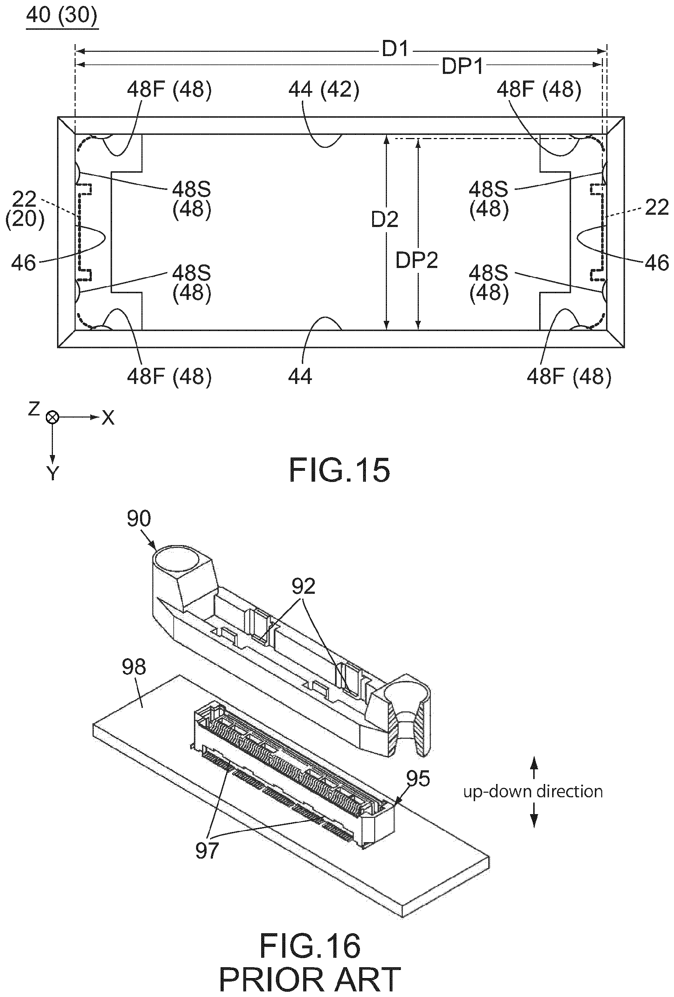

As shown in Figs. 14 and 15, the accommodation portion 42 has two first sides 44 and two second sides 46. The two first side 44 and the two second sides 46 are the four sides of a rectangular. Each of the first sides 44 extends along the first horizontal direction. The two first sides 44 extend in parallel to each other. Each of the second sides 46 extends along the second horizontal direction. The two second sides 46 extend in parallel to each other. In the present embodiment, the first side 44 is longer than the second side 46. Thus, the first sides 44 are the long sides of the rectangular, and the second sides 46 are the short sides of the rectangular. However, the present invention is not limited thereto. For example, the size of the first side 44 may be same as or shorter than the size of the second side 46.

The accommodation portion 42 of the present embodiment is provided with eight press-fit projections 48. The eight press-fit projections 48 consist of four first press-fit projections (press-fit projections) 48F and four second press-fit projections (press-fit projections) 48S. The four first press-fit projections 48F and the four second press-fit projections 48S have shapes similar to each other. Each of the first press-fit projections 48F is provided on one of the first sides 44. Each of the second press-fit projections 48S is provided on one of the second sides 46. In other words, four of the eight press-fit projections 48 provided on the first sides 44 work as the first press-fit projections 48F, and remaining four of the eight press-fit projections 48 provided on the second sides 46 work as the second press-fit projections 48S.

Each of the first press-fit projections 48F projects from one of the first sides 44, which is referred to as a predetermined first side 44, toward a remaining one of the first sides 44, which is referred to as an opposite first side 44. In other words, each of the first press-fit projections 48F projects inward in the second horizontal direction from the predetermined first side 44. Each of the first press-fit projections 48F and the opposite first side 44 are apart from each other by a distance DP2 in the second horizontal direction. The two first sides 44 are apart from each other by a distance D2 in the second horizontal direction. The distance DP2 is shorter than the distance D2.

Each of the second press-fit projections 48S projects from one of the second sides 46, which is referred to as a predetermined second side 46, toward a remaining one of the second sides 46, which is referred to as an opposite second side 46. In other words, each of the second press-fit projections 48S projects inward in the first horizontal direction from the predetermined second side 46. Each of the second press-fit projections 48S and the opposite second side 46 are apart from each other by a distance DP1 in the first horizontal direction. The two second sides 46 are apart from each other by a distance D1 in the first horizontal direction. The distance DP1 is shorter than the distance D1.

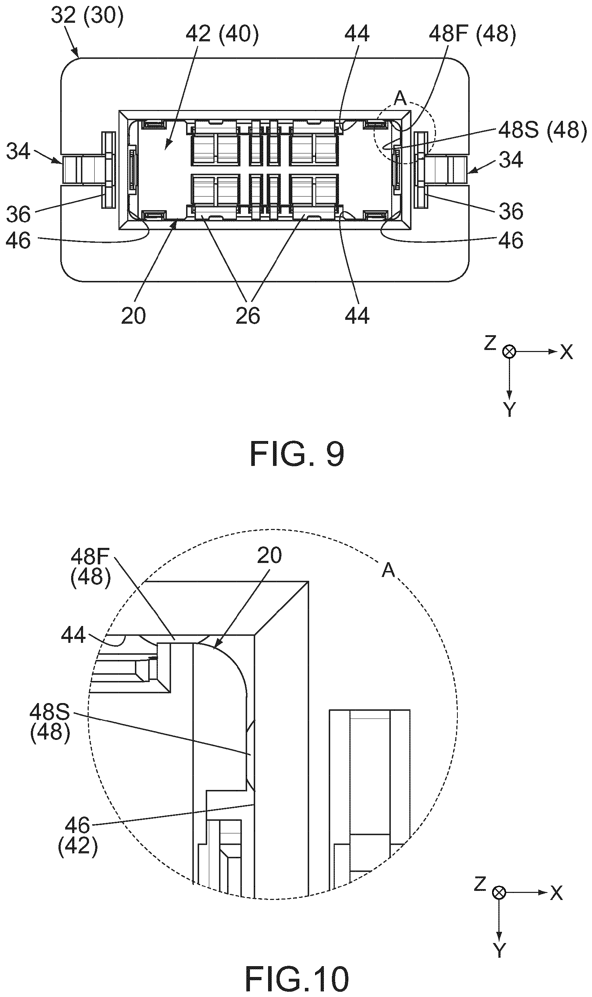

Referring to Fig. 15 together with Figs. 9 and 10, the connector 20 is located in the accommodation portion 42 under the attached state. The connector 20 has a size in the first horizontal direction which is smaller than the distance D1 but is larger than the distance DP1. The connector 20 has a size in the second horizontal direction which is smaller than the distance D2 but is larger than the distance DP2. Accordingly, the connector 20 under the attached state is pressed against the first press-fit projections 48F in the second horizontal direction and is pressed against the second press-fit projections 48S in the first horizontal direction. Thus, the connector 20 is lightly press-fit in the accommodation portion 42 and is reliably positioned relative to the accommodation portion 42 in the horizontal plane.

Summarizing the explanation described above with reference to Figs. 9 and 10, the accommodation portion 42 is provided with at least one first press-fit projection 48F and at least one second press-fit projection 48S. The at least one first press-fit projection 48F projects inward in the horizontal plane from one of the two first sides 44. The at least one second press-fit projection 48S projects inward in the horizontal plane from one of the two second sides 46. Under the attached state, the connector 20 is located in the accommodation portion 42, is pressed against the at least one first press-fit projection 48F in the second horizontal direction and is pressed against the at least one second press-fit projection 48S in the first horizontal direction.

According to the present embodiment, as described above, when the guide component 30 is attached to the connector 20, the connector 20 is pressed against the first press-fit projection 48F to be positioned in the second horizontal direction and is pressed against the second press-fit projection 48S to be positioned in the first horizontal direction. In other words, the guide component 30 is reliably positioned relative to the connector 20 in the horizontal plane defined by the first horizontal direction and the second horizontal direction.

Referring to Figs. 1 and 2, the guide portions 50 of the thus-positioned guide component 30 guide the mating connector 70 toward the connector 20 when the mating connector 70 is mated with the connector 20. The mating connector 70 guided by the guide component 30 can be mated with the connector 20 while being accurately positioned relative to the connector 20 in the horizontal plane. Thus, the present embodiment provides the guide component 30 which can accurately position the mating connector 70 relative to the connector 20 in the horizontal plane.

Referring to Figs. 14 and 15, the number of the first press-fit projections 48F may be one or more, and the number of the second press-fit projections 48S may be one or more.

The guide component 30 can be accurately positioned relative to the connector 20 in the horizontal plane under the attached state even in an instance in which the accommodation portion 42 is provided with only one of the first press-fit projections 48F and only one of the second press-fit projections 48S as shown in a predetermined circle of chain dotted line of Fig. 14. In this instance, the connector 20 is sandwiched and held between the second press-fit projection 48S illustrated in the predetermined circle and the left second side 46 illustrated in Fig. 14 in the first horizontal direction and is sandwiched and held between the first press-fit projection 48F illustrated in the predetermined circle and the lower first side 44 illustrated in Fig. 14 in the second horizontal direction. As a result, the guide component 30 is held so as to be unmovable relative to the connector 20 in the horizontal plane.

According to an instance in which the accommodation portion 42 is provided with only one of the first press-fit projections 48F and only one of the second press-fit projections 48S, the guide component 30 could not be smoothly attached to the connector 20 because of a friction force which might be generated between the connector 20 and at least one of the first side 44 and the second side 46 of the guide component 30. The connector 20 under the attached state might be located at a position which is slightly apart from the middle of the accommodation portion 42. Therefore, as described below, the number of the first press-fit projections 48F is preferred to be two or more, and the number of the second press-fit projections 48S is preferred to be two or more.

According to the present embodiment, the at least one first press-fit projection 48F includes two first press-fit projections 48F, and the at least one second press-fit projection 48S includes two second press-fit projections 48S. The two first press-fit projections 48F project inward in the horizontal plane from the two first sides 44, respectively, and face each other in the second horizontal direction. The two second press-fit projections 48S project inward in the horizontal plane from the two second sides 46, respectively, and face each other in the first horizontal direction. According to this arrangement, when the guide component 30 is attached to the connector 20, only rounded ends of the first press-fit projections 48F and only rounded ends of the second press-fit projections 48S are pressed against the connector 20, and thereby the guide component 30 can be smoothly attached to the connector 20.

In an instance in which the accommodation portion 42 is provided with only two of the first press-fit projections 48F and only two of the second press-fit projections 48S, an imaginary line extending through the two first press-fit projections 48F and another imaginary line extending through the two second press-fit projections 48S are preferred to intersect with each other at the center of the accommodation portion 42 in the horizontal plane. For example, the two first press-fit projections 48F are preferred to be located at the middle points of the first sides 44 in the first horizontal direction, respectively, and the two second press-fit projections 48S are preferred to be located at the middle points of the second sides 46 in the second horizontal direction, respectively. According to this arrangement, the connector 20 under the attached state can be easily located at the middle of the accommodation portion 42.

According to the present embodiment, the at least one first press-fit projection 48F includes two pairs, namely first pairs, each consisting of the two first press-fit projections 48F, and the at least one second press-fit projection 48S includes two pairs, namely second pairs, each consisting of the two second press-fit projections 48S. For each of the first pairs, the two first press-fit projections 48F project inward in the horizontal plane from the two first sides 44, respectively, and face each other in the second horizontal direction. For each of the second pairs, the two second press-fit projections 48S project inward in the horizontal plane from the two second sides 46, respectively, and face each other in the first horizontal direction. According to this arrangement, the guide component 30 can be stably attached to the connector 20.

In an instance in which the accommodation portion 42 is provided with only two of the first pairs and only two of the second pairs, the two first pairs are preferred to be located at opposite ends of the accommodation portion 42 in the first horizontal direction, respectively, and the two second pairs are preferred to be located at opposite ends of the accommodation portion 42 in the second horizontal direction, respectively. According to this arrangement, the connector 20 can be precisely positioned at the middle of the accommodation portion 42 under the attached state.

The arrangement of the first press-fit projections 48F and the second press-fit projections 48S is not limited to the aforementioned arrangements but can be further variously modified. For example, the number of the press-fit projections 48 including the first press-fit projections 48F and the second press-fit projections 48S may be three, nine or more.

Hereafter, explanation will be made about the guide portions 50 (see Fig. 1) of the guide component 30 of the present embodiment.

Referring to Figs. 1 and 2, the two openings 88 of the mating object 80 are located at positions which correspond to positions of the two guide portions 50 of the guide component 30 in the horizontal plane, respectively. When seen from above, the two openings 88 have shapes which are similar to outlines of the two guide portions 50 but are slightly larger than the outlines of the two guide portions 50. The thus-arranged guide portions 50 are inserted into the openings 88, respectively, when the mating connector 70 is mated with the connector 20. As a result, the mating connector 70 is positioned relative to the guide component 30 in the horizontal plane.

According to the present embodiment, the openings 88 receive the upward projecting guide components 30 so that the mating connector 70 is positioned. According to this positioning method, the mating connector 70 can be positioned without enlarging a size between the object 60 and the mating object 80 in the up-down direction under the mated state. In addition, the mating connector 70 can be positioned while the guide portions 50 are viewed through the openings 88.

However, the positioning method of the present invention is not limited to the aforementioned positioning method. For example, each of the guide portions 50 may be formed with a guide hole (not shown). Each of the guide holes may extend along the up-down direction and may open upward. The mating object 80 may be provided with two pins which correspond to the guide holes, respectively. Each of the pins may project downward from the mating object 80. The pins may be received in the guide holes, respectively so that the mating connector 70 can be positioned. According to this positioning method, each of the guide portions 50 may have an upper surface which is located at a position same as that of the upper surface of the base 40 in the up-down direction.

Referring to Figs. 4 and 11, each of the guide portions 50 of the present embodiment has a guide surface 52. Each of the guide surfaces 52 is an inner surface of the guide portion 50 in the first horizontal direction. Each of the guide surfaces 52 has a recessed shape which is recessed outward in the first horizontal direction. In other words, the guide surfaces 52 are recessed away from each other in the first horizontal direction.

Each of the guide surfaces 52 has an upper guide surface 54 and a lower guide surface 56. Each of the lower guide surfaces 56 is a surface consisting of a plane perpendicular to the first horizontal direction and two planes each perpendicular to the second horizontal direction. Each of the lower guide surfaces 56 continuously extends in the horizontal plane. Each of the lower guide surfaces 56 extends upward from an upper end of the accommodation portion 42. Each of the upper guide surfaces 54 is a surface consisting of a plane oblique to the first horizontal direction and two planes each oblique to the second horizontal direction. Each of the upper guide surfaces 54 continuously extends in the horizontal plane. Each of the upper guide surfaces 54 extends upward from an upper end of the lower guide surface 56 while being widened outward in the horizontal plane.

Referring to Fig. 5 together with Fig. 4, the mating connector 70 has an outline in the horizontal plane which is slightly smaller than a rectangular defined by the two lower guide surfaces 56. Even if the mating connector 70 is displaced in the horizontal plane in a process in which the mating connector 70 is mated with the connector 20, the mating connector 70 is guided by the upper guide surfaces 54 to be moved toward the rectangular defined by the two lower guide surfaces 56. Thus, the guide surfaces 52 guide the opposite end portions 72 of the mating connector 70 in the first horizontal direction, respectively, when the mating connector 70 is mated with the connector 20.

Referring to Fig. 1, according to the present embodiment, when the mating connector 70 is mated with the connector 20, a first positioning is performed by the guide portions 50 and the openings 88. Referring to Fig. 5, then, a second positioning is performed by the guide surfaces 52 and the opposite end portions 72 of the mating connector 70. Referring to Figs. 1 and 5, according to the present embodiment, even in an instance in which each of the openings 88 is too large in size on the horizontal plane, the mating connector 70 can be accurately positioned by the second positioning. Accordingly, a damage which might be caused by an abutment of the mating connector 70 with the connector 20 can be prevented. However, the present invention is not limited thereto. For example, the guide surfaces 52 may be provided as necessary.

Referring to Fig. 1 together with Fig. 4, the mating connector 70 of the present embodiment is received in a part of the connector 20 which is located just under the accommodation portion 42 of the guide component 30 under the mated state. Thus, the mating connector 70 has a size which is smaller than a size of the connector 20 in the first horizontal direction. Referring to Fig. 5, the two lower guide surfaces 56 which guide the mating connector 70 are apart from each other in the first horizontal direction by a distance which is smaller than a size of the connector 20 in the first horizontal direction. In other words, the guide portions 50 protrude inward in the first horizontal direction beyond opposite ends of the connector 20 in the first horizontal direction, respectively.

Referring to Fig. 14, according to the aforementioned structure, the guide portions 50 cover the opposite end portions 22 of the connector 20 in the first horizontal direction from above, respectively, under the attached state. However, the present invention is not limited thereto. For example, in an instance in which the connector 20 is received in the mating connector 70 under the mated state, each of the guide portions 50 may be located outward of the end portion 22 of the connector 20 in the first horizontal direction.

While there has been described what is believed to be the preferred embodiment of the invention, those skilled in the art will recognize that other and further modifications may be made thereto without departing from the spirit of the invention, and it is intended to claim all such embodiments that fall within the true scope of the invention.

## Claims

1. A guide component which is configured to be attached to a connector mateable with a mating connector and is configured to guide mating of the connector with the mating connector, wherein:
the guide component has a base and two guide portions;
the base is formed with an accommodation portion;
the accommodation portion passes through the base in an up-down direction and has two first sides and two second sides;
each of the first sides extends along a first horizontal direction perpendicular to the up-down direction;
each of the second sides extends along a second horizontal direction perpendicular to both the up-down direction and the first horizontal direction;
the accommodation portion is provided with at least one first press-fit projection and at least one second press-fit projection;
the at least one first press-fit projection projects inward in a horizontal plane perpendicular to the up-down direction from one of the two first sides;
the at least one second press-fit projection projects inward in the horizontal plane from one of the two second sides;
under an attached state where the guide component is attached to the connector, the connector is located in the accommodation portion, is pressed against the at least one first press-fit projection in the second horizontal direction and is pressed against the at least one second press-fit projection in the first horizontal direction;
the guide portions are located at opposite sides of the base in the first horizontal direction, respectively, with the accommodation portion located therebetween; and
the guide portions guide the mating connector toward the connector when the mating connector is mated with the connector.

2. The guide component as recited in claim 1, wherein:
the at least one first press-fit projection includes two first press-fit projections;
the at least one second press-fit projection includes two second press-fit projections;
the two first press-fit projections project inward in the horizontal plane from the two first sides, respectively, and face each other in the second horizontal direction; and
the two second press-fit projections project inward in the horizontal plane from the two second sides, respectively, and face each other in the first horizontal direction.

3. The guide component as recited in claim 2, wherein:
the at least one first press-fit projection includes two pairs each consisting of the two first press-fit projections; and
the at least one second press-fit projection includes two pairs each consisting of the two second press-fit projections.

4. The guide component as recited in one of claims 1 to 3, wherein:
the connector is configured to be mounted and fixed on an object;
the guide component has a fixed portion; and
the guide component is configured to be fixed to the object by the fixed portion.

5. The guide component as recited in one of claims 1 to 4, wherein:
the mating connector is configured to be mounted and fixed on a mating object;
the mating object is formed with two openings; and
the guide portions are inserted into the openings, respectively, when the mating connector is mated with the connector.

6. The guide component as recited in one of claims 1 to 5, wherein:
each of the guide portions has a guide surface;
the guide surfaces are recessed away from each other in the first horizontal direction; and
the guide surfaces guide opposite ends of the mating connector in the first horizontal direction, respectively, when the mating connector is mated with the connector.

7. The guide component as recited in claim 6, wherein the guide portions cover opposite ends of the connector in the first horizontal direction from above, respectively, under the attached state.
